(19) Europäisches Patentamt
European Patent Office
Office européen des brevets

(11) EP 1 519 229 A2

(12) EUROPEAN PATENT APPLICATION

(43) Date of publication:
30.03.2005 Bulletin 2005/13

(51) Int Cl.7: G03F 7/16

(21) Application number: 04021923.0

(22) Date of filing: 15.09.2004

(84) Designated Contracting States:
AT BE BG CH CY CZ DE DK EE ES FI FR GB GR HU IE IT LI LU MC NL PL PT RO SE SI SK TR
Designated Extension States:
AL HR LT LV MK

(30) Priority: 25.09.2003 DE 10345362

(71) Applicant: Kodak Polychrome Graphics GmbH
37520 Osterode/Harz (DE)

(72) Inventors:
- Hauck, Gerhard
37534 Badenhausen (DE)
- Dallmann, Ulrike
37412 Herzberg (DE)
- Ignatov, Toshko
Sofia-1582 (BG)

(74) Representative: VOSSIUS & PARTNER
Siebertstrasse 4
81675 München (DE)

# (54) Process for the prevention of coating defects

(57) The present invention relates to a coating process comprising

(a) providing a coating solution comprising at least one novolak resin and one or more polar organic solvents,
(b) applying the coating solution onto a substrate, and
(c) drying,

characterized in that particles have been added to the coating solution which (i) are solid at room temperature, (ii) are insoluble in polar organic solvents, (iii) have an average particle size in the range of 0.1 μm to 2 mm and (iv) comprise one or more organic materials as main component(s) or consist thereof.

EP 1 519 229 A2

## Description

The present invention relates to a coating process wherein coating defects can be prevented, in particular coating defects caused by contamination. The invention furthermore relates to coating compositions for use in the coating process.

Nowadays, coatings are applied in a variety of technical fields. There is a large number of coating processes which can basically be divided into the following categories:

(1) Coating from a gaseous or vaporous state (vapor deposition, metallization, plastic metallization);
(2) coating from a liquid, pulpy or pasty state (painting, brushing, varnishing, dispersion coating or hot-melt coating, by extruding, casting, immersing, as hot-melts);
(3) coating from an ionized state by electrolytic or chemical deposition (galvanotechnics, Eloxal process, electrophoretic coating, chemical phoresis);
(4) coating from a solid, i.e. granular or powdery, state (powder coating, flame-spray processes, coating by sintering).

The most common process is the application of a solution, although it does not have to be a solution in the strict sense, but it can also e.g. be a dispersion. Organic solvents are frequently used for such solutions.

It is known that copolymers on the basis of fluoro-substituted (meth)acrylate, which are for example used as flow improvers, surface-smoothing agents and lubricants, often lead to coating defects such as the formation of bubbles, pinholes, craters, etc. during the formation of thin films. If these thin films are radiation-sensitive layers of lithographic printing plate precursors, this leads to poor printing quality. In document EP-A1-1 011 030 it is stated that the coating defects caused by fluoro-substituted copolymers can be prevented if prior to their use in a coating composition, these copolymers are dissolved in a solvent and then treated with an inorganic adsorbent for purification which comprises at least 80 wt.-% silicon oxide, aluminum oxide or a mixture thereof and subsequently filtered; a synthetic adsorbent is mentioned as alternative adsorbent. As another alternative, the purification of the fluoro-substituted copolymers by filtering a solution thereof through a filter with a pore size of 1 µm or less is suggested. Ion exchangers such as different Amberlites from Rohm & Haas and Sepabeads from Mitsubishi Chemical Corporation are mentioned as examples of synthetic adsorbents.

JP-01-149812 describes the purification of fluoro-substituted surface-active copolymers by treating them with a liquid or solid fluorocarbon.

It has been found that coating defects such as "voids" can also occur when the coating solution does not comprise any fluoro-substituted surface-active copolymers. Examinations by the inventors of the present invention have shown that contaminations of the coating solution, e.g. with higher-molecular liquid silicones, can lead to the formation of voids. Higher-molecular silicone oils can get into the coating solution in different ways, e.g. via coating components (such as antifoaming agents), via aerosols (e.g. silicone-containing sprays) and many other sources. It is for example possible that starting products of coating solutions are contaminated with silicones during production or transport. In the present invention, the term "contamination" refers to an undesired component (such as e.g. higher-molecular silicone) present in an amount of <1 wt.-%; typically, undesired contaminations are only present in an amount in the ppm range (i.e. < 0.1 %, in particular < 0.001 %).

It is the object of the present invention to provide a coating process wherein coating defects such as voids are avoided without other properties of the coating being affected; in particular, the radiation sensitivity of radiation-sensitive coatings used for the preparation of lithographic printing plate precursors should not deteriorate.

Another object of the invention is to provide coated objects produced according to the process of the invention.

The first object is surprisingly achieved by a process comprising

(a) providing a coating solution comprising at least one novolak resin and one or more polar organic solvents,
(b) applying the coating solution onto a substrate, and
(c) drying,

characterized in that particles have been added to the coating solution which (i) are solid at room temperature, (ii) are insoluble in polar organic solvents, (iii) have an average particle size in the range of 0.1 µm to 2 mm and (iv) comprise one or more organic materials as main component(s) or consist thereof.

Although the process according to the present invention can be used for many different applications, i.e. for a variety of different coating solutions, it is especially suitable for radiation-sensitive compositions, in particular those used in the production of lithographic printing plate precursors.

As used in the present invention, the term "polar" organic solvent relates to an organic solvent whose polarity, which has been determined empirically and expressed in units of the so-called standardized $E_T(30)$ scale ($E^N_T$ value),

is higher than 0.14, preferably higher than 0.2, with water exhibiting the highest degree of polarity with an $E^N_T$ value of 1.0. The standardized $E^N_T$ values are calculated from the $E_T(30)$ values as follows:

$$E^N_T = \frac{E_T\ (\text{solvent}) - E_T\ (\text{TMS})}{E_T\ (\text{water}) - E_T\ (\text{TMS})} = \frac{E_T\ (\text{solvent}) - 30.7}{32.4}$$

The $E_T$ values and/or $E^N_T$ values are described in the literature for many organic solvents and solvent mixtures. In this connection, reference is made for example to "Solvents and Solvent Effects in Organic Chemistry" by Christian Reichardt, VCH 1988 (2nd edition) and the citations quoted therein.

As used in the present invention, the term "coating solution" relates to a mixture comprising at least one polar organic solvent, at least one binder and optionally further components.

The coating solution used in the process according to the present invention comprises one or more polar organic solvents, which includes both protic and aprotic solvents. Examples thereof include aliphatic and cyclic ethers such as isopropyl ethers and tetrahydrofuran, ethylene and propylene glycol ethers, such as ethyl glycol and Dowanol PM, aliphatic and cyclic ketones, such as acetone, methyl ethyl ketone, methyl isobutyl ketone and cyclohexanone, low-molecular alcohols, such as methanol and 2-propanol, esters, such as ethyl acetate, iso-butyl acetate and ethyl lactate, and glycol ether acetates, such as Dowanol PMA.

According to the present invention, particles are added to the coating solution which

(i) are solid at room temperature,
(ii) are insoluble in polar organic solvents,
(iii) have an average particle size in the range of 0.1 µm to 2 mm, and
(iv) comprise one or more organic materials as main component(s) or consist thereof.

The particles can be filtered off the coating solution and the filtered solution can be applied onto the substrate, or the unfiltered solution (i.e. including the particles) is applied onto the substrate.

The decision of whether or not to filter off the particles also influences the selection of the particles, i.e. their amount, size and nature (in particular their melting point), and vice versa.

If the particles are to be filtered off, in particular, it is preferred that their average size be 1 µm to 2 mm, especially preferred 1 µm to 1 mm, in order to allow filtering with conventional filters (exclusion limit usually 5 µm or 2 µm); however, it is especially preferred that the average particle size not exceed 500 µm, preferably 150 µm, so that a sufficient adsorption surface is provided.

If the particles remain in the coating solution, the average particle size can preferably be 0.1 to 20 µm, especially preferred 4 to 15 µm. If the particles are intended to function as a kind of "spacer" in the coating, e.g. in lithographic printing plate precursors, their average size should be somewhat larger than the thickness of the dried coating and the roughness depth; preferably, it should exceed the depth by some µm (such as e.g. 2 to 8 µm).

In some applications, it may also be desirable to filter the coating solution and not to remove the particles at all or only partially. In these instances, the average particle size and the filtering unit have to be adjusted accordingly.

When the particles remain in the coating solution, i.e. when they are applied onto the substrate together with the solution, it has to be kept in mind that the coating is usually dried at elevated temperatures. If it is not desired that the particles melt upon drying or that several particles may possibly melt together to form larger particles, the particles should consist of a material having a melting point above the drying temperature. Often, the drying temperature is 100 to 140°C; the melting point of the particle material should then be above 140°C, in particular if the hot coating runs over face rollers or even a leveling rollers section.

The amount of particles added is preferably 0.01 to 10 wt.-%, based on the solids content of the coating solution, more preferably 0.05 to 5 wt.-% and particularly preferred 0.2 to 2 wt.-%.

The particles comprise as a main component or consist of one or more organic materials, are solid at room temperature and are insoluble in polar organic solvents. According to one embodiment, the materials are polar organic materials, according to another embodiment, they are apolar organic materials. Examples of suitable materials include straight-chain hydrocarbons (also referred to as "synthetic waxes") and fluorinated derivatives thereof, such as polyethylene and polytetrafluoroethylene, polystyrenes, cross-linked polystyrenes, polyamides, cross-linked polyamides, polymethyl methacrylate, polymethyl methacrylate cross-linked with divinylbenzene and polysiloxanes, as long as they are solid at room temperature and insoluble in polar organic solvents.

Preferably, the materials are apolar organic materials such as polyolefins, fluorinated polyolefins or polysiloxanes.

The dwell time of the particles in the coating solution prior to the application onto the substrate or prior to being filtered off is not particularly restricted; preferably, it is 5 minutes to 24 hours, especially preferred 10 to 60 minutes.

According to a preferred embodiment, the coating solution containing the particles is moved (i.e. shaken or stirred) in order to allow as effective a treatment as possible. It is more preferred that the coating solution be stirred at a stirrer rate of 200 to 5,000 rpm.

The present invention is suitable for all conventional coating solutions comprising one or more polar organic solvents, such as varnishes, and radiation-sensitive compositions for the production of lithographic printing plate precursors, photomasks, and integrated circuit boards.

The coating compositions can for example be positive working or negative working coating compositions. In the field of lithographic printing plates and integrated circuit boards, coating solutions for conventional printing plate precursors/circuit boards (i.e. those that are imaged with UV light) and for heat-sensitive printing plate precursors/circuit boards (i.e. those that are imaged by means of IR lasers or laser diodes) can be used.

Accordingly, depending on the coating type, the components of the coating solution can be selected from polymeric binders, such as novolaks, functionalized novolaks and polyvinyl acetals, free-radical polymerizable monomers, such as (meth)acrylates, (naphtho)quinone diazides, negative working diazo resins, photoinitiators, sensitizers, coinitiators, colorants, IR absorbers, plasticizers, surfactants, flow improvers etc. According to a preferred embodiment, the coating composition does not comprise fluoro-substituted copolymers.

The coating solution can for example comprise novolak resins. Novolak resins are condensation products of one or more suitable phenols, e.g. phenol itself, m-cresol, o-cresol, p-cresol, 2,5-xylenol, 3,5-xylenol, resorcinol, pyrogallol, phenylphenol, diphenols (e.g. bisphenol-A), trisphenol, 1-naphthol and 2-naphthol with one or more suitable aldehydes such as formaldehyde, acetaldehyde, propionaldehyde, benzaldehyde and furfuraldehyde and/or ketones such as e.g. acetone, methyl ethyl ketone and methyl isobutyl ketone. The type of catalyst and the molar ratio of the reactants determine the molecular structure and thus the physical properties of the resin. Phenylphenol, xylenols resorcinol and pyrogallol are preferably not used as single phenol for the condensation but rather in admixture with other phenols. An aldehyde/phenol ratio of about 0.5:1 to 1:1, preferably 0.5:1 to 0.8:1, and an acid catalyst are used in order to produce those phenolic resins known as "novolaks" and having a thermoplastic character. As used in the present application, however, the term "novolak" should also encompass the phenolic resins known as "resols" which are obtained at higher aldehyde/phenol ratios and in the presence of alkaline catalysts as long as they are soluble in aqueous alkaline developers.

If the coating composition is IR-sensitive, it comprises one or more IR absorbers.

The chemical structure of the IR absorber is not particularly restricted, as long as it is capable of converting the radiation it absorbed into heat. In IR-sensitive coatings it is preferred that the IR absorber show essential absorption in the range of 650 to 1,300 nm, preferably 750 to 1,120 nm, and preferably shows an absorption maximum in that range. IR absorbers showing an absorption maximum in the range of 800 to 1,100 nm are especially preferred. The absorbers are for example selected from carbon black, phthalocyanine pigments/dyes and pigments/dyes of the polythiophene-squarylium, thiazoluim-croconate, merocyanine, cyanine, indolizine, pyrylium or metaldithiolin classes, especially preferred from the cyanine class. The compounds mentioned in Table 1 of US-A-6,326,122 for example are suitable IR absorbers. Further examples can be found in US-A-4,327,169, US-A-4,756,993, US-A-5,156,938, WO 00/29214, US-B-6,410,207 and EP-A-1 176 007.

In the class of cyanine dyes, those of formula (I) can for example be mentioned:

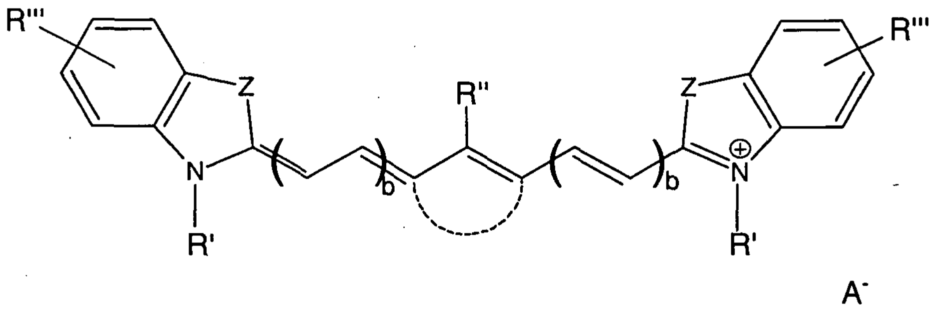

(I)

wherein

each Z independently represents S, O, $NR^a$ or $C(alkyl)_2$;

each R' independently represents an alkyl group, an alkylsulfonate group or an alkylammonium group;

R" represents a halogen atom, $SR^a$, $OR^a$, $SO_2R^a$ or $NR^a{}_2$;

each R''' independently represents a hydrogen atom, an alkyl group, $-COOR^a$, $-OR^a$, $-SR^a$, $-NR^a{}_2$ or a halogen atom;

R''' can also be a benzofused ring;

$A^-$ represents an anion;

--- represents an optionally present carbocyclic five- or six-membered ring;

$R^a$ represents a hydrogen atom, an alkyl or aryl group;

each b can independently be 0, 1, 2 or 3.

If R' represents an alkylsulfonate group, an inner salt can form so that no anion A- is necessary. If R' represents an alkylammonium group, a second counterion is needed which is the same as or different from $A^-$.

Z is preferably a $C(alkyl)_2$ group.

R' is preferably an alkyl group with 1 to 4 carbon atoms.

R'' is preferably a halogen atom or $SR^a$.

R''' is preferably a hydrogen atom.

$R^a$ is preferably an optionally substituted phenyl group or an optionally substituted heteroaromatic group.

The counterion $A^-$ is preferably a chloride ion, trifluoromethylsulfonate or a tosylate anion. Of the IR dyes of formula (I), dyes with a symmetrical structure are especially preferred. Examples of especially preferred dyes include:

2-[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride,

2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride,

2-[2-[2-thiophenyl-3-[2-( 1,3-dihydro-1,3,3-trimethyl-2H-indole-2-ylidene)-ethylidene]-1-cyclopentene-1-yl]-ethenyl]-1,3,3-trimethyl-3H-indoliumtosylate,

2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium-tosylate and

2-[2-[2-chloro-3-[2-ethyl-(3H-benzthiazole-2-ylidene)-ethylidene]-1-cyclohexene-1-yl]-ethenyl]-3-ethyl-benzthiazolium-tosylate.

The following compounds are also IR absorbers:

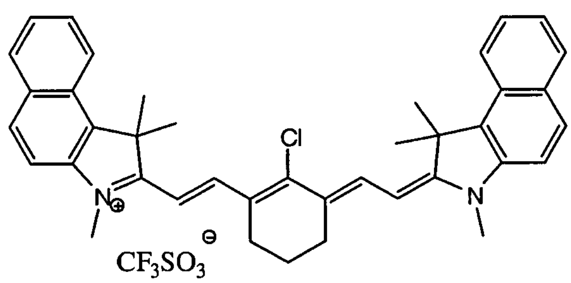

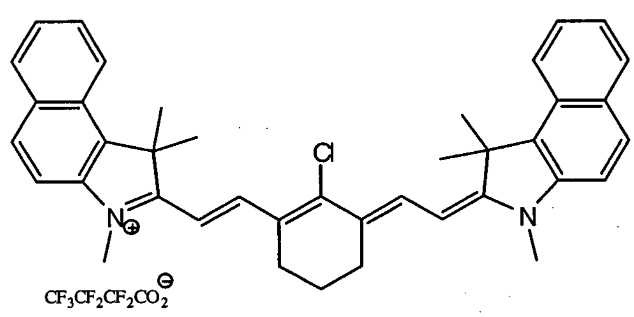

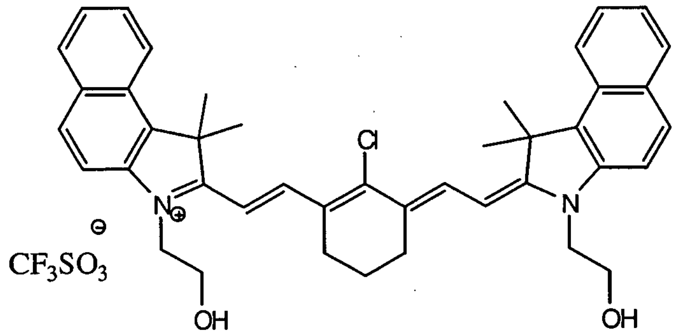

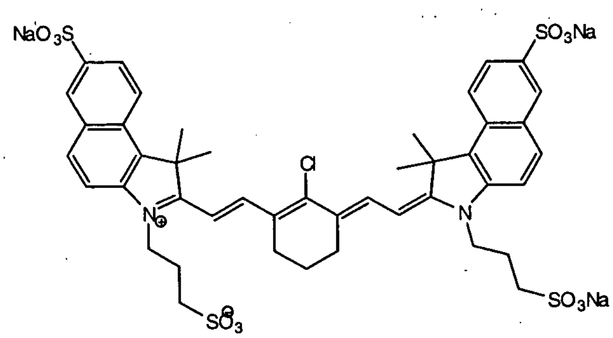

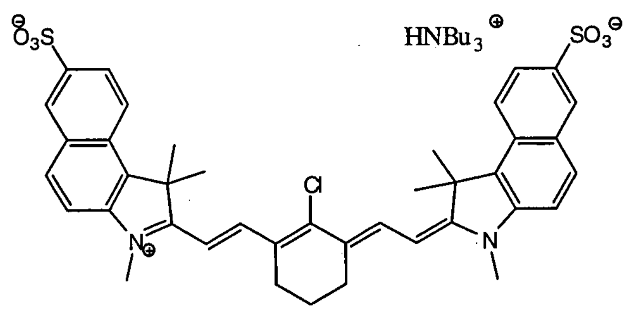

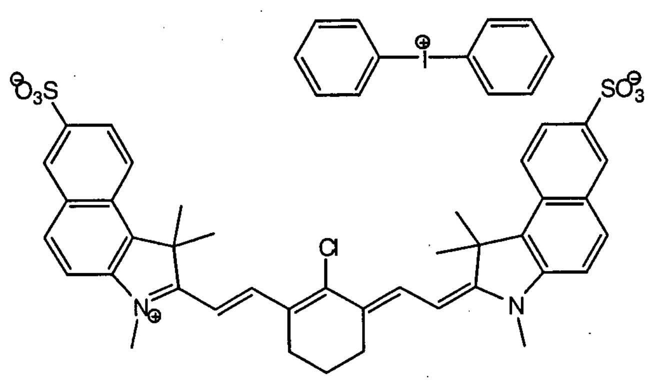

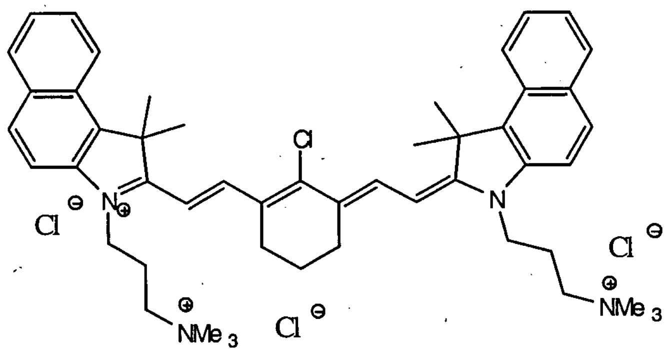

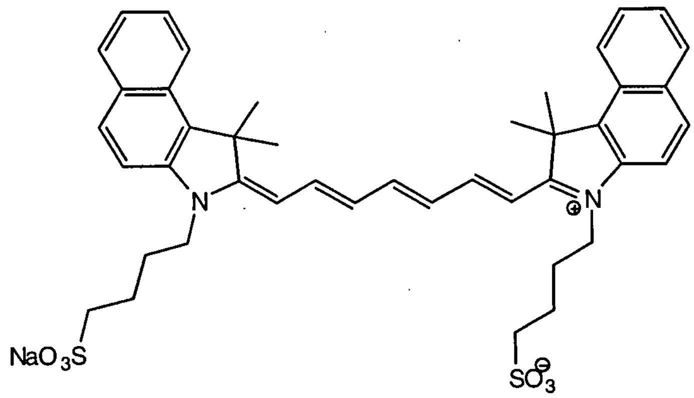

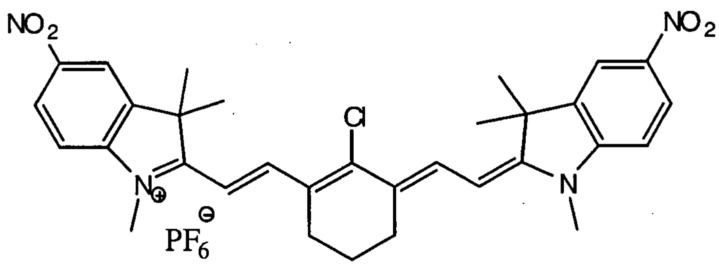

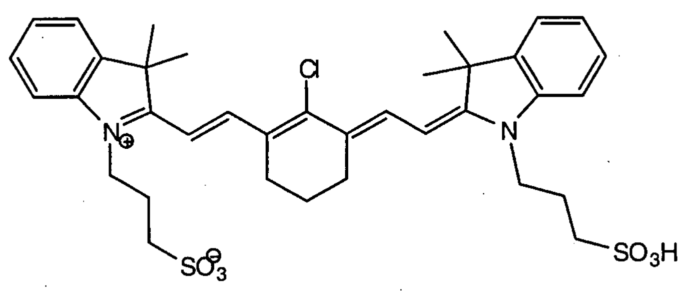

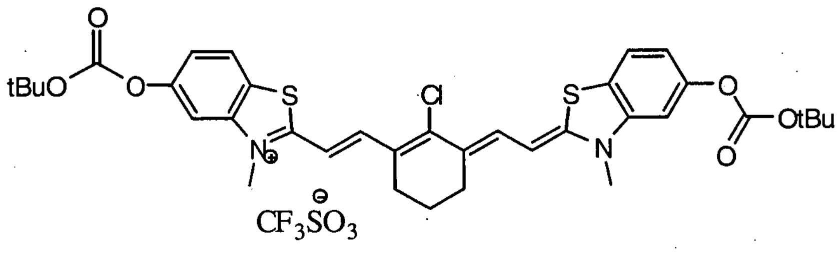

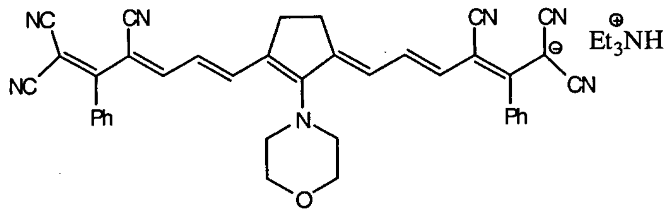

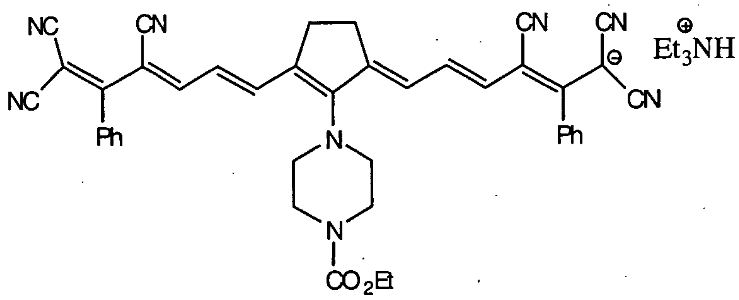

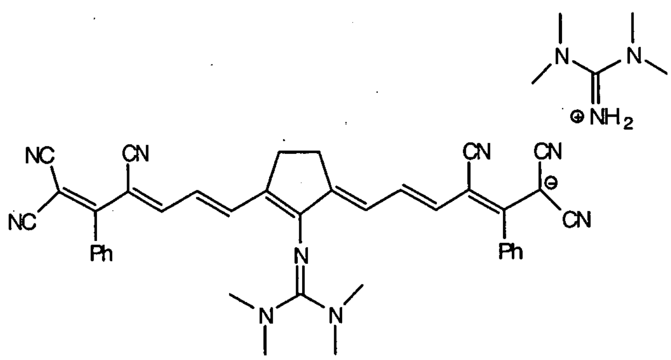

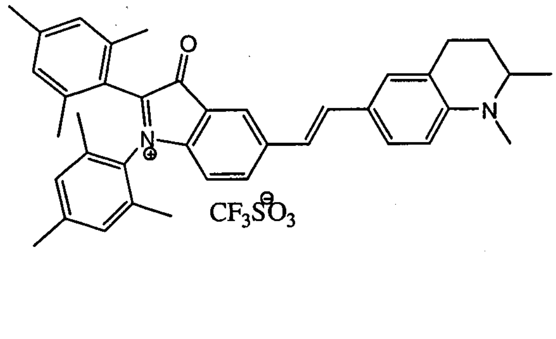

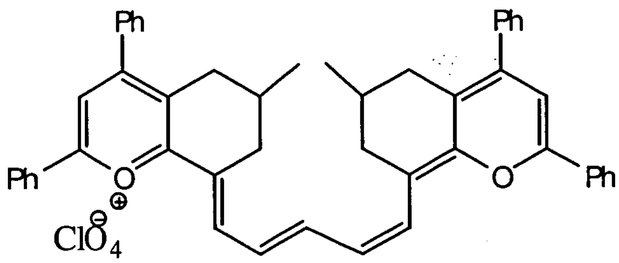

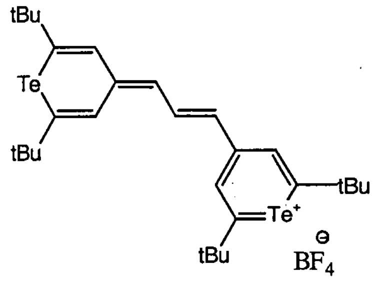

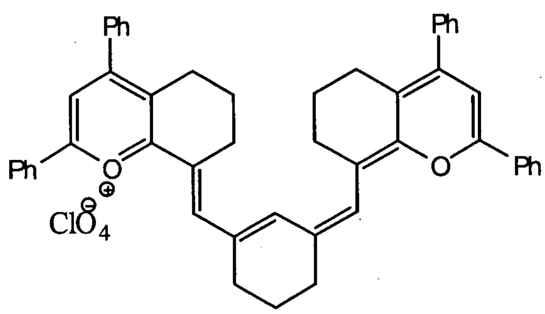

In particular if the coating composition is UV-sensitive, it can for example comprise one or more compounds with a diazo group $=N_2$. In these compounds, the group $=N_2$ is preferably conjugated to carbonyl groups, and it is especially preferred that the carbonyl group be bonded to an aromatic or heteroaromatic ring adjacent to the diazo group. In this connection, especially preferred compounds with diazo groups $=N_2$ are benzoquinone diazides (also referred to simply as quinone diazides) and naphthoquinone diazides with the o-isomers being especially preferred. As used in the present invention, the terms "quinone diazide" and "naphthoquinone diazide" also encompass derivatives thereof. Mixtures of two or more compounds with $=N_2$ groups can also be used.

Examples include 1,2-quinone diazides and 1,2-naphthoquinone diazides, whereby 1,2-naphthoquinone diazides are especially preferred. Of the 1,2-naphthoquinone diazides, 1,2-naphthoquinone-2-diazide-4- and particularly -5-sulfonic acid esters or amides are preferred. Of those, the esters of 1,2-naphthoquinone-2-diazide-4- or -5-sulfonic acid and 2,5-dihydroxy-benzophenone, 2,3,4-trihydroxybenzophenone, 2,3,4-trihydroxy-4'-methyl-benzophenone, 2,3,4-trihydroxy-4'methoxy-benzophenone, 2,3,4,4'-tetrahydroxy-benzophenone, 2,3,4,2',4'-pentahydroxy-benzophenone, 5,5'-dialkanoyl-2,3,4,2',3',4'-hexahydroxy-diphenylmethane (especially 5,5'-diacetyl-2,3,4,2',3',4'-hexahydroxy-diphenylmethane) or 5,5'-dibenzoyl-2,3,4,2',3',4'-hexahydroxy-diphenylmethane are preferred.

In addition to the low-molecular diazide compounds mentioned above, (naphtho)quinone diazides bonded to polymers such as novolaks, which are known to the person skilled in the art, can be used in the coating composition as well.

Examples of suitable (naphtho)quinone diazide compounds can for example also be found in EP 1 102 123 and the U.S. patents cited therein, such as US 2,766,118; 3,046,110; and 3,647,443. Basically, all (naphtho)quinone diazide compounds can be used that are usually used in positive working conventional UV-sensitive coatings.

The coating composition can also comprise polyvinyl acetals, as e.g. described in DE 195 24 851 A1. They are copolymers comprising the units A, B, C, D and E, wherein A is present in an amount of 10 to 60 mole-% and corresponds to the formula

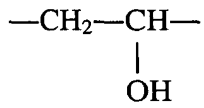 (A)

B is present in an amount of 1 to 30 mole-% and corresponds to the formula

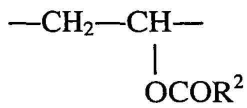 (B)

C is present in an amount of 5 to 60 mole-% and corresponds to the formula

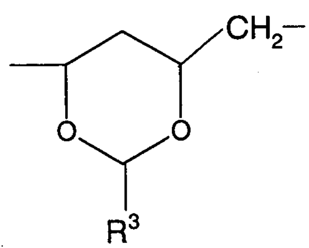 ( C )

D is present in an amount of 5 to 60 mole-% and corresponds to the formula

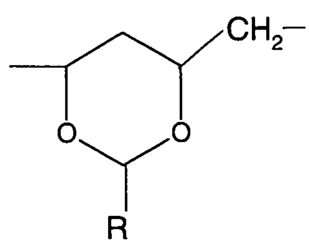 ( D )

and E is present in an amount of 1 to 40 mole-% and corresponds to the formula

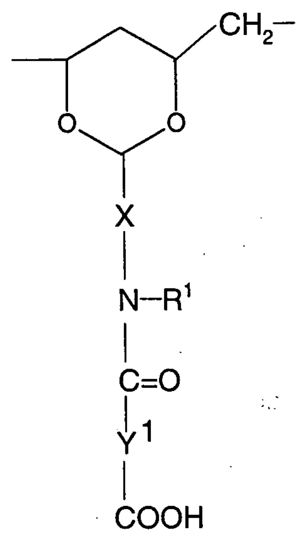

(E)

wherein

| | |
|---|---|
| X | represents an aliphatic, aromatic or araliphatic spacer group, |
| $R^1$ | is a hydrogen atom or an aliphatic, aromatic or araliphatic group, |
| $R^2$, $R^3$ and R | represent alkyl groups with carbon numbers between 1 and 18 and |
| $Y^1$ | is a saturated or unsaturated chain-shaped or ring-shaped spacer group. |

Further suitable polyvinyl acetals are described e.g. in DE 198 47 616 A1, US-B-5,700,619 und US-B-6,596,460.

In particular if the composition is a negative working UV-sensitive composition, it can comprise a negative working diazo resin that has long been known for the use in conventional UV-sensitive coatings of printing plate precursors. Suitable diazo resins are for example diazo resins of formula (II)

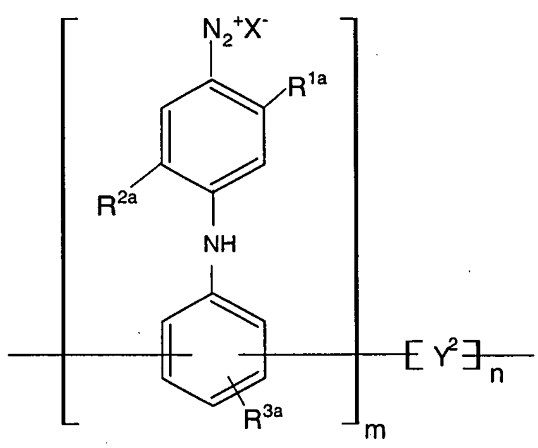

(II)

wherein $R^{1a}$ and $R^{2a}$ independently each represent a hydrogen atom, an alkyl group or an alkoxy group,
$R^{3a}$ represents a hydrogen atom, an alkyl group, an alkoxy group or a group -COOR wherein R is an alkyl group or an aryl group,
$X^-$ is an organic or inorganic anion,
$Y^2$ is a spacer group, and
m/n is a number from 0.5 to 2.

In formula (II), $R^{1a}$ and $R^{2a}$ each independently represent a hydrogen atom, an alkyl group (preferably $C_1$-$C_{18}$, especially preferred $C_1$-$C_{10}$) or an alkoxy group (preferably $C_1$-$C_{18}$, especially preferred $C_1$-$C_{10}$). Preferably, $R^{1a}$ is H

or $-OCH_3$, especially preferred $-OCH_3$; $R^{2a}$ is preferably H or $-OCH_3$, especially preferred $-OCH_3$.

$R^{3a}$ is selected from a hydrogen atom, an alkyl group (preferably $C_1$-$C_{18}$, especially preferred $C_1$-$C_{10}$), an alkoxy group (preferably $C_1$-$C_{18}$, especially preferred $C_1$-$C_{10}$), and the group -COOR, wherein R is an alkyl group (preferably $C_1$-$C_{18}$, especially preferred $C_1$-$C_{10}$) or aryl group (preferably phenyl). It is preferred that $R^{3a}$ represent H-.

X is an organic or inorganic anion. Preferred anions include the anion of tetraphenyl boric acid, the anion of aromatic carboxylic acids, the anion of aromatic sulfonic acids, the anion of a polyfluoroalkyl carboxylic or sulfonic acid, chloride, hexafluorophosphate, tetrafluoroborate, sulfate, dihydrogenphosphate, tetrachlorozincate; of those, the tosylate or mesitylene sulfonate anion is especially preferred.

$Y^2$ is a spacer group, which is introduced into the diazo resin by way of co-condensation of a monomeric diazo compound with a compound selected from aliphatic aldehydes, aromatic aldehydes, phenolethers, aromatic thioethers, aromatic hydrocarbons, aromatic heterocycles and organic acid amides. Examples of $Y^2$ include $-CH_2-$ and $-CH_2-C_6H_4-O-C_6H_4-CH_2-$.

m/n is 0.5 to 2, preferably 0.9 to 1.1 and especially preferred 1.

Monomeric diazo compounds that can be used in the preparation of the diazo resin include for example 4-diazodiphenylamine, 4'-hydroxy-4-diazodiphenylamine, 4'-methoxy-4-diazodiphenylamine, 4'-ethoxy-4-diazodiphenylamine, 4'-n-propoxy-4-diazodiphenylamine, 4'-i-propoxy-4-diazodiphenylamine, 4'-methyl-4-diazodiphenylamine, 4'-ethyl-4-diazodiphenylamine, 4'-n-propyl-4-diazodiphenylamine, 4'-i-propyl-4-diazodiphenylamine, 4'-n-butyl-4-diazodiphenylamine, 4'-hydroxymethyl-4-diazodiphenylamine, 4'-β-hydroxyethyl-4-diazodiphenylamine, 4'-y-hydroxypropyl-4-diazodiphenylamine, 4'-methoxymethyl-4-diazodiphenylamine, 4'-ethoxymethyl-4-diazodiphenylamine, 4'-p-methoxyethyl-4-diazodiphenylamine, 4'-β-ethoxyethyl-4-diazodiphenylamine, 4'-carbomethoxy-4-diazodiphenylamine, 4'-carboxyethoxy-4-diazodiphenylamine, 4'-carboxy-4-diazodiphenylamine, 4-diazo-3-methoxy-diphenylamine, 4-diazo-2-methoxy-diphenylamine, 2'-methoxy-4-diazodiphenylamine, 3-methyl-4-diazodiphenylamine, 3-ethyl-4-diazodiphenylamine, 3'-methyl-4-diazodiphenylamine, 3-ethoxy-4-diazodiphenylamine, 3-hexyloxy-4-diazodiphenylamine, 3-β-hydroxy-ethoxy-4-diazodiphenylamine, 2-methoxy-5'-methyl-4-diazodiphenylamine, 4-diazo-3-methoxy-6-methyldiphenylamine, 3,3'-dimethyl-4-diazodiphenylamine, 3'-n-butoxy-4-diazodiphenylamine, 3,4'-dimethoxy-4-diazodiphenylamine, 2'-carboxy-4-diazodiphenylamine, 4-diazodiphenyl-ether, 4'-methoxy-4-diazodiphenyl-ether, 4'-methyl-4-diazodiphenyl-ether, 3,4'-dimethoxy-4-diazodiphenyl-ether, 4'-carboxy-4-diazodiphenyl-ether, 3,3'-dimethyl-4-diazodiphenyl-ether, 4-diazodiphenylsulfide, 4'-methyl-4-diazodiphenylsulfide and 4'-methyl-2,5-dimethoxy-4-diazodiphenylsulfide, but are not restricted to these compounds.

Preferred reaction partners for the diazo compounds include e.g. formaldehyde, 4,4'-bismethoxy-methyldiphenylether, acetaldehyde, propionaldehyde, butyraldehyde and benzaldehyde, but are not restricted to these compounds. Especially preferred are formaldehyde and 4,4'-bismethoxy-methyldiphenylether. The conditions for the preparation of the diazo resins are well known to the person skilled in the art; reference is made in this connection to US-A-3,849,392.

Especially preferred diazo resins are those obtained by way of co-condensation of formaldehyde and 4-phenylaminobenzene diazonium salt (1:1 condensation product) or 4,4'-bis-methoxymethyldiphenylether and 4-phenylamino-2-methoxybenzene diazonium salt (1:1 condensation product).

According to a preferred embodiment, the coating solution is a positive working radiation-sensitive coating solution.

According to another preferred embodiment, the coating solution is a negative working radiation-sensitive coating solution.

According to another preferred embodiment, the coating solution is UV-sensitive.

According to a preferred embodiment, the coating solution comprises at least one novolak.

The substrates commonly used for the various types of coating are used. In the case of lithographic printing plate precursors, this means that a dimensionally stable plate or foil-shaped material is preferably used as a substrate. Examples of such substrates include paper, paper coated with plastic materials (such as polyethylene, polypropylene, polystyrene), a metal plate or foil, such as e.g. aluminum (including aluminum alloys), plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred since it shows a remarkable degree of dimensional stability; is inexpensive and furthermore exhibits excellent adhesion to the coating. Furthermore, a composite film can be used wherein an aluminum foil has been laminated onto a polyethylene terephthalate film.

A metal substrate, in particular an aluminum substrate, is preferably subjected to a surface treatment, e.g. graining by brushing in a dry state or brushing with abrasive suspensions, or electrochemical graining, e.g. by means of a hydrochloric acid electrolyte, and optionally anodizing.

In order to improve the hydrophilic properties of the surface of the metal substrate that has been grained and

optionally anodically oxidized in sulfuric acid or phosphoric acid, the metal substrate can furthermore be subjected to an aftertreatment with an aqueous solution of e.g. sodium silicate, calcium zirconium fluoride, polyvinylphosphonic acid or phosphoric acid. Within the framework of the present invention, the term "substrate" also encompasses an optionally pretreated substrate exhibiting, for example, a hydrophilizing layer on its surface.

The details of the substrate pretreatment are known to the person skilled in the art.

The coating can be carried out by means of common processes, e.g. coating by means of doctor blades, roll coating, spray coating, coating with a slot coater, and dip coating.

## Examples

### Comparative Examples 1a and 1b

m-/p-Cresol novolak and ethyl violet were dissolved in a weight ratio of 99:1 in a mixture of THF and Dowanol PM (volume ratio 3:1), yielding a solution with a solids content of 10 wt.-%. Enough NM1-100 (a silicone oil from Chemiewerk Nünchritz; linear polymer) was added in this solution under stirring to give a concentration of 10 ppm (Comparative Example 1a).

In Comparative Example 1b, NM1-100 was added in a concentration of 100 ppm.

Both solutions were stirred for an hour with a magnetic stirrer for obtaining a homogeneous mixture.

Both solutions were applied to an electrochemically grained, anodized aluminum substrate hydrophilized with polyvinylphosphonic acid using a wire-wound doctor blade; the dry layer weight after drying in a hot air stream was 2 $g/m^2$ for both solutions.

Coating defects on the plate in the form of large white spots (also referred to as "voids") were visible to the naked eye which indicated that there was no coating on the substrate in these areas.

The plate of Comparative Example 1a showed 10 such "voids" per square meter; the plate of Comparative Example 1b showed 40 per square meter. In other words: The more silicone was contained in the coating solution, the larger the number of coating defects that were observed.

### Examples 1a and 1b

1 g MP-22XF (synthetic wax: particles of straight-chain hydrocarbon with an average particle size of 5.5 µm; available from Micro Powders, Inc.) was added per liter to a coating solution prepared according to Comparative Example 1b and the mixture was stirred for 10 minutes.

A part of this solution was applied to an aluminum substrate as described in Comparative Example 1 (Example 1a).

Another part of the solution was filtered and the filtered solution was applied to an aluminum substrate as described in Comparative Example 1 (Example 1b).

Neither the plate prepared in Example 1a nor the plate prepared in Example 1b showed "voids"; no defects were found when the plates were examined under a microscope.

### Comparative Example 2

Example 1b was repeated, but instead of MP-22XF particles, Syloid ED5 (Silica from Grace; particle size about 6 µm) was used.

The resulting plate showed 40 "voids" per square meter. Thus, inorganic particles were not capable of preventing the coating defects.

### Comparative Example 3

Comparative Example 1b was repeated, but instead of the mixture of THF and Dowanol PM, the following mixture was used: Ethyl glycol, methyl ethyl ketone, methyl isobutyl ketone and iso-butyl acetate (volume ratio 2:2:3:3). 40 "voids" per square meter were visible to the naked eye.

### Examples 2a and 2b

Comparative Example 3 was repeated, but 1 g MP-22XF particles per liter were added to the coating solution.

As described in Example 1, one part of the solution was applied to a pretreated aluminum substrate unfiltered (Example 2a) and one part was applied after having been filtered (Example 2b).

Neither the plate of Example 2a nor the plate of Example 2b showed voids.

### Examples 3a, 3b, 4a and 4b

Examples 1a and 1b were repeated, but instead of MP-22XF, other particles were used:

Example 3: SDy 70 (particles of cross-linked polystyrene, average particle diameter 6 μm; available from Eastman Kodak)

Example 4: Orgasol 2001 ExDNat 1 (polyamide particles, available from Elf Atochem; average particle size 10 μm)

Both in Example 3 and in Example 4 there were no voids on the plates, regardless of whether the filtered or the unfiltered solution was used.

### Example 5

Using a wire-wound doctor blade, the following coating solution was applied to an electrochemically grained, anodized aluminum substrate hydrophilized with polyvinylphosphonic acid without filtering off the MP-22XF particles (dry layer weight about 2 g/m$^2$):

| | |
|---|---|
| 98 g | of a reaction product of m-/p-cresol novolak and 2,1,4-naphthoquinonediazide sulfonylchloride, |
| 1.5 g | ethyl violet and |
| 0.5 g | 2,4-trichloromethyl-6[1(4-methoxy)naphthyl]-1,3,5-triazine |
| 900 g | solvent (consisting of Dowanol PM) |

as well as

| | |
|---|---|
| 1 g | MP-22XF per liter of coating solution |

Prior to application, the coating solution had been stirred for 10 minutes at 1,000 rpm, evenly distributing the MP-22XF particles.

No "voids" were observed on the coated plate.

The printing plate precursor was subsequently image-wise exposed in a conventional manner with a UV lamp and developed with an alkaline developer. It was found that compared to a printing plate precursor whose coating does not comprise MP-22XF particles, the MP-22XF particles do not affect the photosensitivity of the coating and its developability.

## Claims

**1.** Coating process comprising

(a) providing a coating solution comprising at least one novolak resin and one or more polar organic solvents,
(b) applying the coating solution onto a substrate, and
(c) drying,

**characterized in that** particles have been added to the coating solution which (i) are solid at room temperature, (ii) are insoluble in polar organic solvents, (iii) have an average particle size in the range of 0.1 μm to 2 mm and (iv) comprise one or more organic materials as main component(s) or consist thereof.

**2.** Process according to claim 1, wherein the particles are removed from the coating solution by filtration prior to step (b).

**3.** Process according to claim 1, wherein the particles furthermore have a melting point above the drying temperature used in step (c).

**4.** Process according to claim 1 or 3, wherein the particles are not filtered off prior to step (b).

**5.** Process according to claim 2, wherein the particles have an average particle size of 1 μm to 1 mm.

**6.** Process according to claim 4, wherein the particles have an average particle size of 0.1 to 20 µm.

**7.** Process according to any of claims 1 to 6, wherein the coating solution comprises at least one radiation-sensitive component.

**8.** Process according to any of claims 1 to 7, wherein the substrate is a metal substrate.

**9.** Process according to any of claims 1 to 8, wherein the particles consist of at least one of the following materials or comprise at least one of the following materials as the main component: Polyolefins, fluorinated polyolefins, polystyrenes, cross-linked polystyrenes, polyamides, cross-linked polyamides, polymethyl methacrylate, polymethyl methacrylate cross-linked with divinylbenzene, polysiloxanes.

**10.** Process according to any of claims 1 to 9, wherein the coating solution is prepared by mixing all components of the coating solution except the particles with the at least one polar solvent one after another or at the same time and then adding the particles.

**11.** Process according to any of claims 1 to 10, wherein the dwell time of the particles in the coating solution prior to step (b) is at least 5 minutes.

**12.** Process according to any of claims 1 to 11, wherein the amount of particles in the coating solution is 0.01 to 10 wt.-%, based on the solids content of the coating solution.

**13.** Process according to claim 1 or 4, wherein the average particle size is smaller than the thickness of the dried coating.

**14.** Process according to claim 1 or 4, wherein the average particle size is larger than the thickness of the dried coating.

**15.** Process for the preparation of a lithographic printing plate precursor, comprising

(a) providing a coating solution comprising at least one novolak resin, at least one radiation-sensitive component and one or more polar organic solvents
(b) applying the coating solution onto a lithographic substrate and
(c) drying

**characterized in that** particles have been added to the coating solution which (i) are solid at room temperature, (ii) are insoluble in polar organic solvents, (iii) have an average particle size in the range of 0.1 µm to 2 mm and (iv) comprise one or more organic materials as main component(s) or consist thereof.

**16.** Coated object, obtainable by the process according to any of claims 1 to 14.

**17.** Precursor of a lithographic printing plate obtainable by the process according to claim 15.

**18.** Coating composition comprising one or more polar organic solvents and particles which

(i) are solid at room temperature,
(ii) are insoluble in polar organic solvents,
(iii) have an average particle size in the range of 0.1 µm to 2 mm, and
(iv) comprise one or more organic materials as main component(s) or consist thereof.

**19.** Coating composition according to claim 18, wherein the composition additionally comprises at least one radiation-sensitive component.

**20.** Use of particles which

(i) are solid at room temperature,
(ii) are insoluble in polar organic solvents,
(iii) have an average particle size in the range of 0.1 µm to 2 mm, and
(iv) comprise one or more organic materials as main component(s) or consist thereof

for removing silicones soluble in polar organic solvents from coating solutions contaminated therewith, said coating solutions comprising one or more polar organic solvents.

**21.** Use according to claim 20, wherein the contaminated coating solution is a radiation-sensitive coating solution.

**22.** Process for preventing coating defects when coating with a solution in polar organic solvents, comprising treating the coating solution prior to applying the coating solution onto the substrate with particles which

(i) are solid at room temperature,
(ii) are insoluble in polar organic solvents,
(iii) have an average particle size in the range of 0.1 µm to 2, and
(iv) comprise one or more organic materials as main component(s) or consist thereof.

**23.** Process according to claim 22, wherein the coating solution is a radiation-sensitive coating solution.